(19) Europäisches Patentamt
European Patent Office
Office européen des brevets

(11) Numéro de publication: **0 210 876**
**A1**

(12) # DEMANDE DE BREVET EUROPEEN

(21) Numéro de dépôt: **86400754.7**

(22) Date de dépôt: **08.04.86**

(51) Int.Cl.[4]: **G 01 R 27/00**
**G 01 R 27/14, G 01 R 27/20**

(30) Priorité: **25.06.85 CA 485172**

(43) Date de publication de la demande:
**04.02.87 Bulletin 87/6**

(84) Etats contractants désignés:
**AT BE CH DE FR GB IT LI LU NL SE**

(71) Demandeur: **HYDRO-QUEBEC**
**75, Boulevard Dorchester Ouest**
**Montréal Québec H2Z 1A4(CA)**

(72) Inventeur: **Morin, François**
**2680 Labonté**
**Longueil Quebec J4L 2J4(CA)**

(74) Mandataire: **Bressand, Georges et al,**
**c/o CABINET LAVOIX 2 Place d'Estienne d'Orves**
**F-75441 Paris Cedex 09(FR)**

(54) **Méthode et ohmètre pour la mesure de très faibles résistances électriques.**

(57) La présente invention concerne un ohmètre pour mesurer des très faibles résistances électriques, par exemple la très faible résistance (8) d'un raccord électrique (7) à très fort courant. Une source (1) est prévue pour établir un courant de mesure (i) à travers le raccord (7) pour ainsi créer une chute de tension proportionnelle á l'intensité du courant de mesure (i) et à la résistance (8) à mesurer. Un premier intégrateur (31) intègre un signal représentatif de l'intensité du courant de mesure (i) afin de produire un premier signal d'intégration, tandis qu'un second intégrateur (24) intègre la chute de tension proportionnelle au courant de mesure (i) et à la très faible résistance (8) pour ainsi produire un second signal d'intégration. Les deux intégrateurs (24, 31) sont remis à zéro simultanément de sorte qu'ils amorcent leurs intégrations en un même instant. Le premier signal d'intégration est comparé à un signal de référence (V ref) à l' aide d'un comparateur (41). Lorsque l'amplitude du premier signal d'intégration atteint l'amplitude du signal de référence (V ref), le comparateur (41) émet un signal qui interrompt l'intégration effectuée par le second intégrateur (24). Le second signal d'intégration est alors mémorisé, celui-ci ayant une amplitude qui constitue une mesure de la très faible résistance électrique (8). Un dispositif d'affichage (54) reçoit le signal d'intégration mémorisé pour afficher la valeur de la résistance mesurée (8).

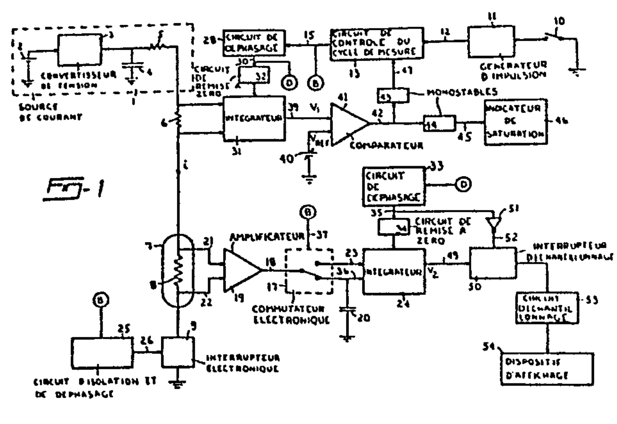


FIG-1

EP 0 210 876 A1

Méthode et ohmètre pour la mesure de très faibles résistances électriques.-

La présente invention concerne un ohmmètre ainsi qu'une méthode pour mesurer des très faibles résistances électriques.

La méthode traditionnelle de mesure des résistances électriques de 100 microohms ou moins est l'utilisation d'un pont de Kelvin. Cette méthode traditionnelle permet de mesurer de façon précise des résistances aussi faibles que 0.1 microohm, mais présente le désavantage de nécessiter une attention particulière et une compétence technique certaine de la part de l'opérateur. De plus, la méthode de mesure d'une très faible résistance électrique à l'aide d'un pont de Kelvin est très longue et fastidieuse, et peut donc difficilement s'appliquer dans les cas où un grand nombre de résistances doivent être mesurées.

Une autre méthode dite des quatre électrodes est présentement couramment utilisée pour la mesure des très faibles résistances des raccords électriques à très fort courant.

L'utilité d'une telle mesure réside en ce qu'une résistance trop grande d'un raccord électrique à très fort courant provoque un échauffement pouvant conduire à la production d'arcs, à l'endommagement du raccord lui-même, à l'endommagement de l'équipement environnant, etc... . Il est donc très important de mesurer cette grandeur lors de la mise en service d'équipements à très fort courant tout comme au cours de périodes d'entretien périodique qui suivent habituellement. De plus, la résistance électrique de ces raccords est intimement liée à la tenue mécanique de ceux-ci. La mesure de la résistance électrique d'un raccord à très fort courant permet donc de déduire, jusqu'à un certain point, la résistance mécanique du raccord.

Selon la méthode des quatre électrodes, un courant continu constant de l'ordre de 10 ampères est établi à travers le raccord électrique, et la chute de tension ainsi créée aux bornes du raccord est mesurée, cette chute de tension étant proportionnelle à la fois à la très faible résistance électrique du raccord et au courant dans celui-ci. Comme la chute de tension mesurée est faible et afin d'éliminer l'influence des forces électromotrices parasites d'origine thermique (effet de thermocouple causé par la connexion des électrodes de mesure de la chute de tension aux bornes du raccord) sur la mesure de la résistance, on produit une inversion du courant continu établi à travers le raccord, on mesure la chute de tension ainsi créée aux bornes du raccord, et on fait la moyenne des deux tensions mesurées correspondant aux deux directions du courant continu pour ainsi obtenir une mesure de la résistance électrique. Un désavantage de cette méthode est qu'elle nécessite l'établissement d'un fort courant continu rigoureusement constant pendant une période de temps relativement longue pour permettre de mesurer de façon précise la très faible résistance électrique. De plus, la conception d'un appareil portatif et autonome pour mettre en oeuvre une telle méthode nécessite l'utilisation d'une batterie à fort courant qui est relativement lourde et qui donc rend plus laborieux le transport d'un tel appareil. De plus, le courant délivré par la batterie varie en pratique de façon non négligeable et affecte en conséquence la précision de la mesure.

Un autre désavantage inhérent à la méthode des quatre électrodes est que le fort courant continu établi pendant une période de temps relativement longue cause un échauffement des électrodes d'amenée du courant continu et éventuellement d'autres éléments d'amenée de ce courant.

Le but de la présente invention est d'éliminer les désavantages des méthodes antérieures discutés plus haut en proposant un ohmmètre ainsi qu'une méthode pour la mesure de très faibles résistances électriques qui soient faciles à mettre en oeuvre même pour le personnel non familier à ce genre de mesure, qui ne nécessitent pas l'établissement d'un courant continu rigoureusement constant, et qui permettent de mesurer la très faible résistance électrique dans une période de temps très courte de sorte qu'une lourde batterie d'alimentation n'est plus nécessaire dans le cas d'un ohmmètre portatif.

Plus particulièrement, la présente invention propose une méthode de mesure d'une très faible résistance électrique comprenant les étapes suivantes:

produire un courant de mesure passant à travers un objet conducteur d'électricité présentant ladite très faible résistance pour ainsi créer une chute de tension proportionnelle à la fois à l'intensité du courant de mesure et à ladite très faible résistance électrique;

produire un signal représentatif de l'intensité du courant de mesure;

intégrer en fonction du temps à partir d'un même instant le signal représentatif de l'intensité du courant de mesure afin de produire un premier signal d'intégration, et la chute de tension proportionnelle à l'intensité du courant de mesure et à ladite très faible résistance électrique afin de produire un second signal d'intégration;

comparer le premier signal d'intégration avec un signal de référence d'amplitude prédéterminée; et

interrompre l'intégration de la chute de tension proportionnelle à l'intensité du courant de mesure et ladite très faible résistance électrique lorsque la comparaison du premier signal d'intégration avec le signal de référence indique que le premier signal d'intégration a atteint une amplitude égale à l'amplitude prédéterminée du signal de référence;

le second signal d'intégration ayant lors de l'interruption de l'intégration de la chute de tension proportionnelle à l'intensité du courant de mesure et à la très faible résistance électrique une amplitude qui constitue une mesure de ladite très faible résistance électrique.

La présente invention propose également un ohmmètre pour mesurer une très faible résistance électrique, comprenant:

une source d'énergie électrique pour délivrer un courant de mesure passant à travers un objet conducteur d'électricité présentant ladite très faible résistance pour ainsi créer une chute de tension proportionnelle à la fois à l'intensité du courant de mesure et à la très faible résistance électrique;

des moyens de détection du courant de mesure pour produire un signal représentatif de l'intensité de ce courant de mesure;

des premier moyens d'intégration pour intégrer en fonction du temps le signal représentatif de l'intensité du courant de mesure afin de produire un premier signal d'intégration;

des seconds moyens d'intégration pour intégrer en fonction du temps la chute de tension proportionnelle à l'intensité du courant de mesure et à la très faible résistance électrique afin de produire un second signal d'intégration;

des moyens de contrôle des premiers et seconds moyens d'intégration pour amorcer simultanément l'intégration du signal représentatif de l'intensité du courant de mesure effectuée par les premiers moyens d'intégration et l'intégration de ladite chute de tension effectuée par les seconds moyens d'intégration ; et

des moyens pour comparer le premier signal d'intégration avec un signal de référence d'amplitude prédéterminée, et pour interrompre l'intégration de ladite chute de tension effectuée par les seconds moyens d'intégration lorsque le premier signal d'intégration atteint une amplitude égale à l'amplitude prédéterminée du signal de référence;

le second signal d'intégration ayant lors de l'interruption de l'intégration de ladite chute de tension effectuée par les seconds moyens d'intégration une amplitude qui constitue une mesure de ladite très faible résistance électrique.

L'intégration du signal représentatif de l'intensité du courant de mesure et l'intégration de la chute de tension proportionnelle à l'intensité du courant de mesure et à la très faible résistance électrique permet d'effectuer de façon très rapide la mesure de résistance avec un courant pas nécessairement constant, de sorte qu'une source de courant à décharge capacitive puisse être utilisée pour délivrer le courant de mesure et ainsi réduire le poids et l'encombrement de l'ohmmètre.

Les avantages et autres caractéristiques de la présente invention apparaîtront plus clairement à la lecture de la description qui suit d'un mode de réalisation préféré de celle-ci, donné à titre d'exemple non-limitatif seulement, avec référence aux dessins annexés, dans lesquels:

La Figure 1 est un schéma synoptique du circuit d'un ohmmètre selon la présente invention;

La Figure 2 illustre des signaux démontrant le fonctionnement de l'ohmmètre de la Figure 1; et

La Figure 3 illustre un phénomène parasite d'origine inductive se produisant lors du fonctionnement mètre de la Figure 1.

Tel qu'illustré à la Figure 1 des dessins, l'ohmmètre comporte une source de courant 1 à décharge capacitive comprenant un groupe de piles 2 facilement disponibles sur le marché, par exemple des piles de 9 volts ou de type C, et un convertisseur de tension courant continu-courant continu (CC-CC) 3 pour élever la tension délivrée par les piles 2 à un niveau requis. La tension relativement élevée délivrée à la sortie du convertisseur 3 charge un condensateur 4 à forte capacité qui constitue en fait un accumulateur d'énergie électrique. La source de courant 1 à décharge capacitive comporte finalement une résistance 5 dont la valeur est sélectionnée pour limiter à un certain niveau le courant de mesure i délivré par la source 1.

La source de courant 1 est donc par sa structure légère et peu encombrante bien qu'elle puisse délivrer par décharge du condensateur 4 un courant i pulsé de sortie de l'ordre de 20 à 30 ampères, ce qui est nettement suffisant pour le fonctionnement de l'ohmmètre selon l'invention. L'utilisation d'une telle source 1 est rendue possible grâce au circuit de mesure qui ne requiert pas un courant de mesure i constant et qui effectue la mesure de résistance très rapidement, tel qu'il sera discuté plus en détails ci-après. La légèreté et le faible encombrement de la source de courant 1 permet donc de concevoir un ohmmètre portatif complètement autonome de poids et d'encombrement réduits. Evidemment, les piles 2 peuvent en plus de charger le condensateur 4 à travers le convertiseur 3 alimenter le reste du circuit du ohmmètre de la Figure 1.

Le courant de mesure i délivré par la source 1 circule à travers une résistance shunt 6 prévue pour produire entre ses bornes un signal représentatif de l'intensité du courant de mesure i, et à travers un objet conducteur d'électricité 7 présentant la très faible résistance électrique à mesurer 8, lorsqu'un interrupteur électronique 9 ferme la boucle principale comprenant la source 1, la résistance 6 et l'objet 7. Il est à noter que lorsque le courant i circule à travers l'objet conducteur d'électricité 7, une chute de tension proportionnelle à la fois à la très faible résistance à mesurer 8 et au courant de mesure i est créée.

Chaque cycle de mesure effectué par l'ohmmètre de la Figure 1 est déclenché par la fermeture d'un interrupteur 10 du type bouton-poussoir pour ainsi connecter à la terre une entrée d'un générateur d'impulsion 11. Ce générateur d'impulsion 11 en réponse à la fermeture de l'interrupteur 10 délivre une impulsion sur sa sortie 12, cette impulsion étant identifiée par la référence A sur la Figure 2 des dessins.

L'impulsion A à la sortie 12 du générateur 11 est transmise à un circuit de contrôle du cycle de mesure 13. En réponse au front descendant 14 de l'impulsion A, le circuit de contrôle 13 fait subir au signal B qu'il émet sur sa sortie 15 une transition niveau logique haut - niveau logique bas 16 tel qu'illustré sur la Figure 2 des dessins.

Il convient ici d'ouvrir une parenthèse pour mentionner que lorsque le signal B a un niveau logique haut, c'est-à-dire avant l'arrivée du front descendant 14 de l'impulsion A, un commutateur électronique 17 recevant sur une entrée de contrôle 37 le signal B interconnecte la sortie 18 d'un amplificateur à faible signal 19 à un condensateur de mémorisation 20. Cet amplificateur 19 comporte deux entrées 21 et 22 connectées à l'objet 7 par l'intermédiaire d'électrodes appropriées de manière à pouvoir amplifier la chute de tension générée par le courant de mesure i et la très faible résistance à mesurer 8. Il est en effet nécessaire d'amplifier cette chute de tension à cause de la faible valeur de la résistance 8 qui produit par conséquent une faible chute de tension en réponse au courant i.

La fonction du condensateur de mémorisation 20 est de mémoriser une force électromotrice parasite due principalement à un effet de thermocouple produit par le contact des électrodes de connexion des deux entrées 21 et 22 de l'amplificateur 19 avec l'objet conducteur d'électricité 7, et de façon secondaire à la dérive de la sortie 18 de cet amplificateur 19. La mémorisation de cette force électromotrice parasite est possible puisque le courant de mesure i n'est établi qu'après que le front descendant 14 de l'impulsion A ne soit survenu tel que décrit ci-après.

Lorsque le signal B présente un niveau logique bas après la transition 16, le commutateur électronique 17 déconnecte le condensateur de mémorisation 20 de la sortie 18 de l'amplificateur 19 et interconnecte cette sortie 18 à une entrée 23 d'un intégrateur 24.

Le signal B est également transmis à un circuit d'isolation et de déphasage 25 associé à l'interrupteur électronique 9. Ce circuit 25 délivre sur sa sortie 26 en réponse au signal B un signal C illustré à la Figure 2 et appliqué à une entrée de l'interrupteur 9. En réponse à la transition niveau logique haut - niveau logique bas 16 du signal B, le circuit d'isolation et de déphasage 25 produit sur sa sortie 26 une transition niveau logique bas - niveau logique haut 27 du signal C après un court délai $t_1$ induit, par exemple, par un coupleur optique faisant partie du circuit 25 et ayant pour fonction d'isoler l'interrupteur électronique 9 du reste du circuit de l'ohmmètre.

Lorsque le signal C présente un niveau logique haut après la transition 27, l'interrupteur électronique 9 ferme la boucle principale comprenant la source 1, la résistance 6 et l'objet 7 afin d'établir le courant de mesure i par décharge du condensateur 4.

En réponse à la transition 16 du signal B à la sortie 15 du circuit de contrôle 13, un circuit de déphasage 28 produit après un délai $t_2$ une transition niveau logique haut - niveau logique bas 29 d'un signal D illustré à la Figure 2 et qu'il délivre sur sa sortie 30, afin d'amorcer le fonctionnement d'un intégrateur 31 en désactivant un circuit de remise à zéro 32. La transition 29 du signal D est aussi transmise sans délai à travers un circuit de déphasage 33 pour desactiver un circuit de remise à zéro 34 et ainsi amorcer le fonctionnement de l'intégrateur 24. Le signal appliqué par la sortie 35 du circuit de déphasage 33 au circuit de remise à zéro 34 est identifié par la lettre E sur la Figure 2 des dessins.

Donc, l'intégration effectuée par l'intégrateur 31 et l'intégration effectuée par l'intégrateur 24 sont amorcées simultanément.

Lors de la remise à zéro des deux intégrateurs, l'intégrateur 31 amorce l'intégration en fonction du temps de la chute de tension aux bornes de la résistance 6 qui est représentative de l'intensité du courant de mesure i, tandis que l'intégrateur 24 amorce l'intégration en fonction du temps de la tension proportionnelle à la très faible résistance 8 et au courant de mesure i qui est amplifiée par l'amplificateur 19. La force électromotrice parasite mémorisée dans le condensateur 20 et due principalement à l'effet de thermocouple et de façon secondaire à la portion non contrôlée de la tension de décalage (dérive lente) de la sortie 18 de l'amplificateur 19 est appliquée à une entrée 36 de l'intégrateur 24, tandis que la chute de tension proportionnelle à la très faible résistance 8 et à l'intensité du courant de mesure i amplifiée par l'amplificateur 19 et additionnée de la force électromotrice parasite qui a été auparavant mémorisée dans le condensateur 20, est appliquée à l'entrée 23 de l'intégrateur 24 à travers le commutateur 17. Comme l'intégrateur 24 intègre la tension présente entre ses entrées 23 et 36, il n'intègre que la chute de tension produite par le courant de mesure i et la résistance électrique à mesurer 8, et, la force électromotrice parasite due principalement à l'effet de thermocouple et, de façon secondaire, à la dérive lente de la sortie 18 de l'amplificateur 19 n'influence donc pas l'intégration de la chute de tension proportionnelle au courant i et à la résistance 8.

Il est à noter qu'un condensateur de mémorisation n'est pas nécessaire à l'entrée de l'intégrateur 31 puisque, dans ce cas, l'effet de tension parasite d'origine thermique y est totalement négligeable à cause de la valeur plus élevée de la résistance 6, et par conséquent de la valeur plus élevée de la chute de tension créée aux bornes de celle-ci et qui est intégrée par l'intégrateur 31.

Le fonctionnement de l'ohmmètre doit aussi tenir compte des effets parasites d'origine inductive qui peuvent se produire et qui sont conséquents à l'utilisation d'une source de courant pulsée de forte intensité. On comprend plus facilement ce phénomène d'induction en se rapportant à la Figure 3 des dessins où sont identifiées de façon simplifiée en négligeant la résistance 6 les composantes les plus importantes de ces effets. Il s'agit, en l'occurrence, des inductances parasites L1 à L5. Ces effets parasites s'expliquent comme suit: la commutation extrêmement rapide du courant de mesure i produit une surtension importante et subite aux bornes de l'objet présentant la très faible résistance 8. La résistance 5 joue alors un rôle peu important sur l'impédance totale du circuit et la surtension provient ainsi du diviseur de tension correspondant à

$$\frac{L2}{(L1 + L2 + L3 + L5)}.$$

Afin d'éliminer l'effet des inductances parasites L1 à L5 sur la mesure de la très faible résistance 8, on maintient tout d'abord le courant pulsé de mesure i à une valeur raisonnable, de l'ordre de 20 à 30 ampères. On atténue ainsi les phénomènes d'inductance parasite précédemment décrits tout en disposant d'une chute de tension, faible certes pour une résistance électrique à mesurer de l'ordre du microohm, mais suffisante si un amplificateur 19 de qualité appropriée est utilisé. En introduisant un délai $t_3$ (voir Figure 2) entre l'établissement du courant de mesure i (transition 27 de la Figure 2) et le début des intégrations effectuées par les intégrateurs 31 et 24 (transitions 29 et 38 de la Figure 2), on réussit à éliminer en grande partie, sinon complètement, l'effet des transitoires rapides dues aux inductances parasites précitées.

L'intégrateur 31 délivre à sa sortie 39 un signal d'intégration $V_1$ qui est comparé à l'aide d'un comparateur 41 à une tension de référence $V_{REF}$ générée par une source de tension réglable 40. Lorsque le signal d'intégration $V_1$ atteint une amplitude égale à celle de la tension de référence $V_{REF}$ produite par la source 40, le comparateur 41 délivre sur sa sortie 42 un signal qui active un monostable de remise à zéro 43 et un second monostable 44.

0210876

Le monostable 44 génère alors une impulsion sur sa sortie 45 pour alimenter pendant une durée suffisamment longue un indicateur de saturation 46 qui indique que le cycle de mesure fonctionne de façon satisfaisante. Le signal délivré par le monostable 44 sur sa sortie 45 est identifié par la référence F sur la Figure 2 des dessins.

Lorsqu'activé par la sortie 42 du comparateur 41, le monostable de remise à zéro 43 produit sur sa sortie 47 une impulsion G illustrée sur la Figure 2 des dessins. Cette impulsion G est transmise au circuit de contrôle du cycle de mesure 13 qui produit aussitôt en réponse au front montant de l'impulsion G une transition niveau logique bas - niveau logique haut 48 du signal B délivré sur sa sortie 15.

La transition 48 du signal B agit sur le commutateur électronique 17 pour déconnecter aussitôt la sortie 18 de l'amplificateur 19 de l'entrée 23 de l'intégrateur 24 de sorte que l'intégration effectuée par cet intégrateur est aussitôt interrompue. Le signal d'intégration $V_2$ délivré par l'intégrateur 24 sur sa sortie 49 constitue alors une mesure de la résistance électrique 8.

La sortie 18 de l'amplificateur 19 se retrouve donc après la transition 48 reconnectée au condensateur de mémorisation 20 jusqu'au prochain cycle de mesure.

Le comparateur 41 permet donc d'interrompre l'intégration de la chute de tension produite à travers l'objet conducteur d'électricité 7 par ladite très faible résistance 8 et le courant i après qu'une quantité de courant prédéterminée soit passée au travers de cet objet 7. L'utilisation du comparateur 41 a donc l'avantage d'établir automatiquement la quantité de courant nécessaire à la mesure de la résistance 8.

Comme la transition 38 du signal E délivré sur la sortie 35 du circuit de déphasage 33 est transmise à un interrupteur d'échantillonnage 50 après inversion par le circuit d'inversion 51, l'interrupteur 50 est fermé aussitôt que la transition 38 du signal E se produit. Le signal à la sortie 52 du circuit d'inversion 51 est identifié par la référence H sur la Figure 2 des dessins.

Le signal d'intégration $V_2$ retenu sur la sortie 49 de l'intégrateur 24 après l'interruption de l'intégration effectuée par ce dernier est donc transmis à un circuit d'échantillonnage 53 par l'intermédiaire de l'interrupteur 50. Le signal d'intégration $V_2$ mémorisé par le circuit d'échantillonnage 53 après l'interruption de l'intégration effectuée par l'intégrateur 24 est transmis à un dispositif d'affichage 54 qui affiche la valeur de la très faible résistance électrique mesurée 8 en réponse à ce signal.

Le cycle de mesure réalisé par l'ohmmètre de la Figure 1 se termine comme suit.

La transition 48 du signal B à la sortie 15 du circuit de contrôle du cycle de mesure 13 produit une transition 55 du signal D à la sortie du circuit de déphasage 28 après un délai $t_4$ (voir Figure 2) introduit par ce circuit 28. La transition 55 est donc appliquée au circuit de remise à zéro 32 de l'intégrateur 31 pour ainsi arrêter le fonctionnement de ce dernier.

La transition 48 du signal B est aussi appliquée au circuit d'isolation et de déphasage 25 qui ouvre l'interrupteur électronique 9 après un délai $t_5$ (voir Figure 2) suivant la transition 48. Le circuit 25 introduit le délai $t_5$ afin que de nouveaux effets d'inductance parasite produits par l'interruption brusque du courant de mesure i ne viennent perturber la mesure de la très faible résistance 8.

La transition 55 du signal D délivré à la sortie 30 du circuit de déphasage 28 est appliquée au circuit de déphasage 33 qui produit à sa sortie 35 une transition niveau logique bas - niveau logique haut 56 du signal E après un délai $t_6$ suivant la transition 48. La transition 56 est appliquée au circuit de remise à zéro 34 pour interrompre le fonctionnement de l'intégrateur 24. La transition 56 du signal E est aussi transmise à l'interrupteur d'échantillonnage 50 par l'intermédiaire du circuit d'inversion 51 tel qu'illustré à la Figure 2 par le signal H pour ainsi ouvrir l'interrupteur 50. Il est à noter que le délai $t_6$ est introduit par les circuits 28 et 33 afin de donner suffisamment de temps au circuit d'échantillonnage 53 pour mémoriser la valeur finale du signal d'intégration $V_2$ délivré par l'intégrateur 24.

Nous verrons maintenant par un développement mathématique simple de quelle façon l'amplitude du signal d'intégration $V_2$ constitue une mesure de la très faible résistance 8 lors de l'interruption de l'intégration effectuée par l'intégrateur 24.

Tout d'abord, les amplitudes des signaux d'intégration $V_1$ et $V_2$ délivrés par les intégrateurs 31 et 24, respectivement, lors de l'interruption de l'intégration effectuée par l'intégrateur 24 peuvent être exprimés comme suit:

$$V_1 = V_{REF} = C_1 \, R_6 \, I$$

$$V_2 = C_2 \, R_8 \, I$$

où $C_1$ est la constante d'intégration de l'intégrateur 31, $C_2$ la constante d'intégration associée à l'intégrateur 24, $R_6$ la valeur de la résistance 6, $R_8$ la valeur de la très faible résistance 8 à mesurer, et I est le résultat de l'intégrale du courant de mesure i dans la période de temps considérée.

En divisant $V_2$ par $V_1$, on obtient:

$$\frac{V_2}{V_1} = \frac{C_2 \, R_8}{C_1 \, R_6}$$

comme $V_1 = V_{REF}$, on obtient:

$$R_8 = \frac{C_1 \, R_6}{C_2} \; \frac{V_2}{V_{REF}} = C_3 \, V_2$$

où $C_3$ est une constante égale à $\dfrac{C_1 \, R_6}{C_2 \, V_{REF}}$

puisque $C_1$ et $C_2$ sont des constantes associées aux intégrateurs 31 et 24, respectivement, et la résistance $R_6$ et la tension $V_{REF}$ sont aussi des constantes.

L'ohmmètre de la Figure 1 peut donc être calibré en ajustant la constante d'intégration $C_1$, la constante d'intégration $C_2$ et/ou la valeur de la résistance 6, de sorte que la tension $V_2$ mémorisée par le circuit d'échantillonnage 53 permette au circuit d'affichage 54 de donner une lecture correspondant à la mesure de la très faible résistance 8. Evidemment, la calibration de l'ohmmètre pourrait aussi éventuellement être effectuée au moins en partie à travers la structure du circuit d'affichage 54.

Pour modifier la gamme de résistances qui peuvent être mesurées par l' ohmmètre, par exemple pour passer de la mesure de résistances de l'ordre du microohm à la mesure de résistances de l'ordre de quelques dizaines de microohms, il suffit d'ajuster en conséquence certains paramètres de l'ohmètre tels que la valeur de la résistance 6, la constante $C_1$ de l'intégrateur 31, le gain de l'amplificateur 19, la constante d'intégration $C_2$, l'amplitude de la tension de référence $V_{REF}$, etc.

La structure et le fonctionnement de l'ohmmètre selon l'invention sont donc très simples tout en permettant de mesurer avec précision des très faibles résistances électriques d'un certain niveau, par exemple de l'ordre du microohm, donné par l'ajustement des paramètres mentionnés ci-dessus.

De plus, la mesure de la résistance électrique 8 est effectuée très rapidement, c'est-à-dire dans un délai de l'ordre de quelques millisecondes, grâce à l'utilisation des intégrateurs 24 et 31, et du comparateur 41. Le courant de mesure i ne doit donc circuler que durant un très bref instant de sorte que tout phénomène d'échauffement causé par ce courant i est annulé et que l'utilisation d'une source de courant à décharge capacitive est rendue possible.

Quelques applications intéressantes de l'ohmmètre de la Figure 1 sont les suivantes: mesure de la résistance des raccords électriques à fort courant, essais non-destructifs pour les joints soudés par mesure de la résistance de ces joints, mesure de la résistance des contacts de disjoncteurs, etc... .

Pour la mesure de la résistance électrique des raccords à très fort courant, le convertisseur de tension 3 de la source de courant 1 délivre une tension qui charge le condensateur 4 et qui est suffisamment élevée pour soumettre le raccord électrique à des conditions représentatives de celles qu'il subit lors de son utilisation.

Bien que la présente invention ait été décrite à l'aide d'un mode préféré de réalisation de celle-ci, il doit être noté que toute modificationdel'ohmmètre ou de la méthode selon l'invention ne doit pas être considérée, à condition de respecter l'étendue des revendications annexées, comme changeant ou altérant la nature de la présente invention.

Les réalisations de l'invention au sujet desquelles un droit exclusif de propriété ou de privilège est revendiqué sont définies comme suit :

1. Un ohmmètre pour mesurer une très faible résistance électrique, comprenant :

une source d'énergie électrique (1) pour délivrer un courant de mesure (i) passant à travers un objet conducteur d'électricité (7) présentant ladite très faible résistance (8) pour ainsi créer une chute de tension proportionnelle à la fois à l'intensité du courant de mesure (i) et à ladite très faible résistance électrique (8) ;

des moyens (6) de détection du courant de mesure (i) pour produire un signal représentatif de l'intensité dudit courant de mesure ;

des premiers moyens d'intégration (31) pour intégrer en fonction du temps le signal représentatif de l'intensité du courant de mesure (i) afin de produire un premier signal d'intégration ;

des seconds moyens d'intégration (17, 19, 20, 24) pour intégrer en fonction du temps ladite chute de tension proportionnelle à l'intensité du courant de mesure (i) et à ladite très faible résistance électrique (8) afin de produire un second signal d'intégration ;

des moyens de contrôle (13, 28, 32, 33, 34) desdits premiers (31) et seconds (17, 19, 20, 24) moyens d'intégration pour amorcer simultanément l'intégration du signal représentatif de l'intensité du courant de mesure (i) effectuée par les premiers moyens d'intégration (31) et l'intégration de ladite chute de tension effectuée par les seconds moyens d'intégration (17, 19, 20, 24); et

des moyens (13, 40, 41, 43) pour comparer ledit premier signal d'intégration avec un signal de référence (V ref) d'amplitude prédéterminée, et pour interrompre l'intégration de ladite chute de tension effectuée par les seconds moyens d'intégration (17, 19, 20, 24) lorsque le premier signal d'intégration atteint une amplitude égale à l'amplitude prédéterminée du signal de référence (V ref) ;

le second signal d'intégration ayant lors de l'interruption de l'intégration de ladite chute de tension effectuée par lesdits seconds moyens d'intégration (17, 19, 20, 24) une amplitude qui constitue une mesure de ladite très faible résistance électrique (8).

2. Un ohmmètre selon la revendication 1, caractérisé en ce que ladite source d'énergie électrique (1) est une source de courant à décharge capacitive comprenant un condensateur (4) à forte capacité qui délivre ledit courant de mesure (i) après avoir été chargé.

3. Un ohmmètre selon la revendication 2, caractérisé en ce que ladite source d'énergie électrique (1) comporte en outre au moins une pile (2) qui délivre une tension continue et des moyens d'élévation (3) de la tension continue délivrée par ladite au moins une pile (2) pour produire une tension continue d'amplitude plus élevée qui charge ledit condensateur (4) à forte capacité.

4. Un ohmmètre selon la revendication 1, caractérisé en ce que lesdits moyens de détection du courant de mesure (i) comportent une résistance (6) à travers laquelle circule ledit courant de mesure (i), cette résistance (6) produisant une chute de tension constituant ledit signal représentatif de l'intensité du courant de mesure (i).

5. Un ohmmètre selon la revendication 4, caractérisé en ce que lesdits premiers moyens d'intégration comprennent un intégrateur (31) pour intégrer la chute de tension constituant ledit signal représentatif de l'intensité du courant de mesure (i).

6. Un ohmmètre selon la revendication 1, caractérisé en ce que lesdits moyens de comparaison et d'interruption comprennent un comparateur (41) ayant une première entrée recevant le premier signal d'intégration, une seconde entrée recevant le signal de référence (V réf) d'amplitude prédéterminée généré par une source de tension (40), et une sortie (42) qui délivre un signal indiquant que le premier signal d'intégration a une amplitude soit plus faible que l'amplitude prédéterminée du signal de référence

(V ref), soit égale ou plus élevée que l'amplitude prédéterminée dudit signal de référence (V ref).

7. Un ohmmètre selon la revendication 6, caractérisé en ce qu'il comporte des moyens (44, 46) pour indiquer que le premier signal d'intégration a une amplitude égale ou plus élevée que l'amplitude prédéterminée dudit signal de référence (V ref) en réponse au signal de sortie dudit comparateur (41).

8. Un ohmmètre selon la revendication 1, caractérisé en ce que lesdits seconds moyens d'intégration comprennent un circuit d'amplification (19) pour amplifier ladite chute de tension proportionnelle à la fois à l'intensité du courant de mesure (i) et à ladite très faible résistance électrique (8) afin de produire une chute de tension amplifiée, et un intégrateur (24) pour intégrer ladite chute de tension amplifiée.

9. Un ohmmètre selon la revendication 8, caractérisé en ce qu'une force électromotrice parasite due à un effet de thermocouple est produite par des connexions dudit ohmmètre à l'objet conducteur d'électricité (7), cette force électromotrice parasite étant amplifiée par ledit circuit d'amplification (19), lesdits seconds moyens d'intégration comportant des moyens de commutation (17) interposés entre le circuit d'amplification (19) et ledit intégrateur (24) qui comporte une première entrée (23), une seconde entrée (36) reliée à un condensateur (20) et des moyens pour intégrer une tension présente entre lesdites première (23) et seconde (36) entrées, les moyens de commutation (17) comprenant des moyens pour transmettre, lorsque le courant de mesure (i) n'est pas délivré par la source d'énergie électrique (1), la force électromotrice parasite amplifiée à ladite seconde entrée (36) et donc au condensateur (20) de sorte que ce condensateur (20) mémorise ladite force électromotrice parasite amplifiée, les moyens de commutation (17) comportant également des moyens pour transmettre, lorsque ledit courant de mesure (i) est délivré par la source d'énergie électrique (1), la chute de tension amplifiée additionnée de la force électromotrice parasite amplifiée à la première entrée (23) dudit intégrateur (24).

10. Un ohmmètre selon la revendication 8, caractérisé en ce que lesdits seconds moyens d'intégration comportent un commutateur électronique (17) interposé entre le circuit d'amplification (19) et ledit intégrateur (24) et en ce que lesdits moyens de comparaison et d'interruption comportent des moyens (13) pour contrôler ledit commutateur électronique (17) afin de déconnecter une sortie (18) du circuit d'amplification (19) sur laquelle est délivrée ladite chute de tension amplifiée d'une entrée (23) dudit intégrateur (24) pour ainsi interrompre l'intégration de ladite chute de tension amplifiée effectuée par ledit intégrateur (24).

11. Un ohmmètre selon la revendication 1, caractérisé en ce qu'il comprend des moyens (20) pour mémoriser une force électromotrice parasite due à un effet de thermocouple produit par des connexions de l'ohmmètre audit objet conducteur d'électricité (7).

12. Un ohmmètre selon la revendication 11, caractérisé en ce que lesdits seconds moyens d'intégration comportent un intégrateur (24) muni d'une première entrée (23), d'une seconde entrée (36) et de moyens pour intégrer une tension présente entre lesdites première (23) et seconde (36) entrées, la force électromotrice parasite mémorisée étant appliquée à ladite seconde entrée (36) tandis que ladite chute de tension additionnée de la force électromotrice parasite est appliquée à ladite première entrée (23).

13. Un ohmmètre selon la revendication 1, caractérisé en ce que lesdits moyens de contrôle desdits premiers (31) et seconds (17, 19, 20, 24) moyens d'intégration comportent des moyens (13, 28, 32, 33, 34) pour remettre simultanément à zéro lesdits premiers (31) et seconds (17, 19, 20, 24) moyens d'intégration.

14. Un ohmmètre selon la revendication 1, caractérisé en ce que lesdits moyens de contrôle desdits premiers (31) et seconds (17, 19, 20, 24) moyens d'intégration comprennent des moyens (13, 28, 32, 33, 34) pour amorcer simultanément l'intégration effectuée par les premiers moyens d'intégration (31) et l'intégration effectuée par les seconds moyens d'intégration (17, 19, 20, 24) après une certaine période de temps ($t_3$) suivant l'établissement du courant de mesure (i) à travers ledit objet conducteur d'électricité (7) de manière à annuler au moins en partie l'influence de phénomènes parasites d'origine inductive sur la mesure de ladite très faible résistance électrique (8).

15. Un ohmmètre selon la revendication 1, caractérisé en ce qu'il comprend des moyens (53) pour mémoriser le second signal d'intégration après l'interruption de l'intégration de ladite chute de tension effectuée par les seconds moyens d'intégration (17, 19, 20, 24).

16. Un ohmmètre selon la revendication 15, caractérisé en ce qu'il comporte un circuit d'affichage (54) pour afficher la valeur de ladite très faible résistance électrique mesurée (8) en réponse audit second signal d'intégration mémorisée dans lesdits moyens de mémorisation (53).

17. Un ohmmètre selon la revendication 1, caractérisé en ce que lesdits moyens de détection du courant de mesure (i) comportent une résistance (6) à travers laquelle circule ledit courant de mesure (i), lesdits premiers moyens d'intégration comportent un premier intégrateur (31) ayant une première constante d'intégration, et les seconds moyens d'intégration comportent un second intégrateur (24) ayant une seconde constante d'intégration, ledit ohmmètre étant calibré par l'ajustement de la valeur de ladite résistance (6) des moyens de détection du courant de mesure (i), par l'ajustement de la première constante d'intégration, et/ou par l'ajustement de la seconde constante d'intégration.

18. Un ohmmètre selon la revendication 1, caractérisé en ce qu'il comprend en outre des moyens (25, 9) pour interrompre le courant de mesure (i) après un court

délai ($t_5$) suivant l'interruption de l'intégration de ladite chute de tension effectuée par les seconds moyens d'intégration (17, 19, 20, 24).

19. Un ohmmètre selon la revendication 1, caractérisé en ce qu'il comporte des moyens (9) pour établir le courant de mesure (i) délivré par la source d'énergie électrique (1) pendant seulement une courte période de temps pour ainsi éviter tout phénomène d'échauffement causé par le courant de mesure (i).

20. Un ohmmètre selon la revendication 1, caractérisé en ce que ledit objet conducteur d'électricité (7) est un raccord électrique à fort courant, et en ce que ladite source d'énergie électrique (1) comporte des moyens (2, 3) pour produire une tension suffisamment élevée pour soumettre le raccord électrique à des conditions représentatives de celles qu'il subit lors de son utilisation.

21. Une méthode de mesure d'une très faible résistance électrique comprenant les étapes suivantes :

produire un courant de mesure (i) passant à travers un objet conducteur d'électricité (7) présentant ladite très faible résistance (8) pour ainsi créer une chute de tension proportionnelle à la fois à l'intensité du courant de mesure (i) et à ladite très faible résistance électrique (8) ;

produire un signal représentatif de l'intensité dudit courant de mesure (i) ;

intégrer en fonction du temps à partir d'un même instant le signal représentatif de l'intensité dudit courant de mesure (i) afin de produire un premier signal d'intégration, et ladite chute de tension proportionnelle à l'intensité du courant de mesure (i) et à ladite très faible résistance électrique (8) afin de produire un second signal d'intégration ;

comparer ledit premier signal d'intégration avec un signal de référence ($V_{ref}$) d'amplitude prédéterminée; et

interrompre l'intégration de la chute de tension proportionnelle à l'intensité du courant de mesure (i) et à ladite très faible résistance électrique (8) lorsque ladite comparaison dudit premier signal d'intégration avec le signal de référence (V ref) indique que le premier signal d'intégration a atteint une amplitude égale à l'amplitude prédéterminée du signal de référence (V ref) ;

le second signal d'intégration ayant lors de l'interruption de l'intégration de ladite chute de tension proportionnelle à l'intensité du courant de mesure (i) et à la très faible résistance électrique (8) une amplitude qui constitue une mesure de ladite très faible résistance électrique (8).

22. Une méthode de mesure selon la revendication 21, caractérisée en ce qu'elle comprend en outre une étape de mémorisation du second signal d'intégration présent lors de l'interruption de l'intégration de ladite chute de tension proportionnelle à l'intensité du courant de mesure (i) et à ladite très faible résistance électrique (8).

23. Une méthode selon la revendication 22, caractérisée en ce qu'elle comporte en outre une étape d'affichage de la mesure de ladite très faible résistance électrique (8) en réponse audit second signal d'intégration mémorisé.

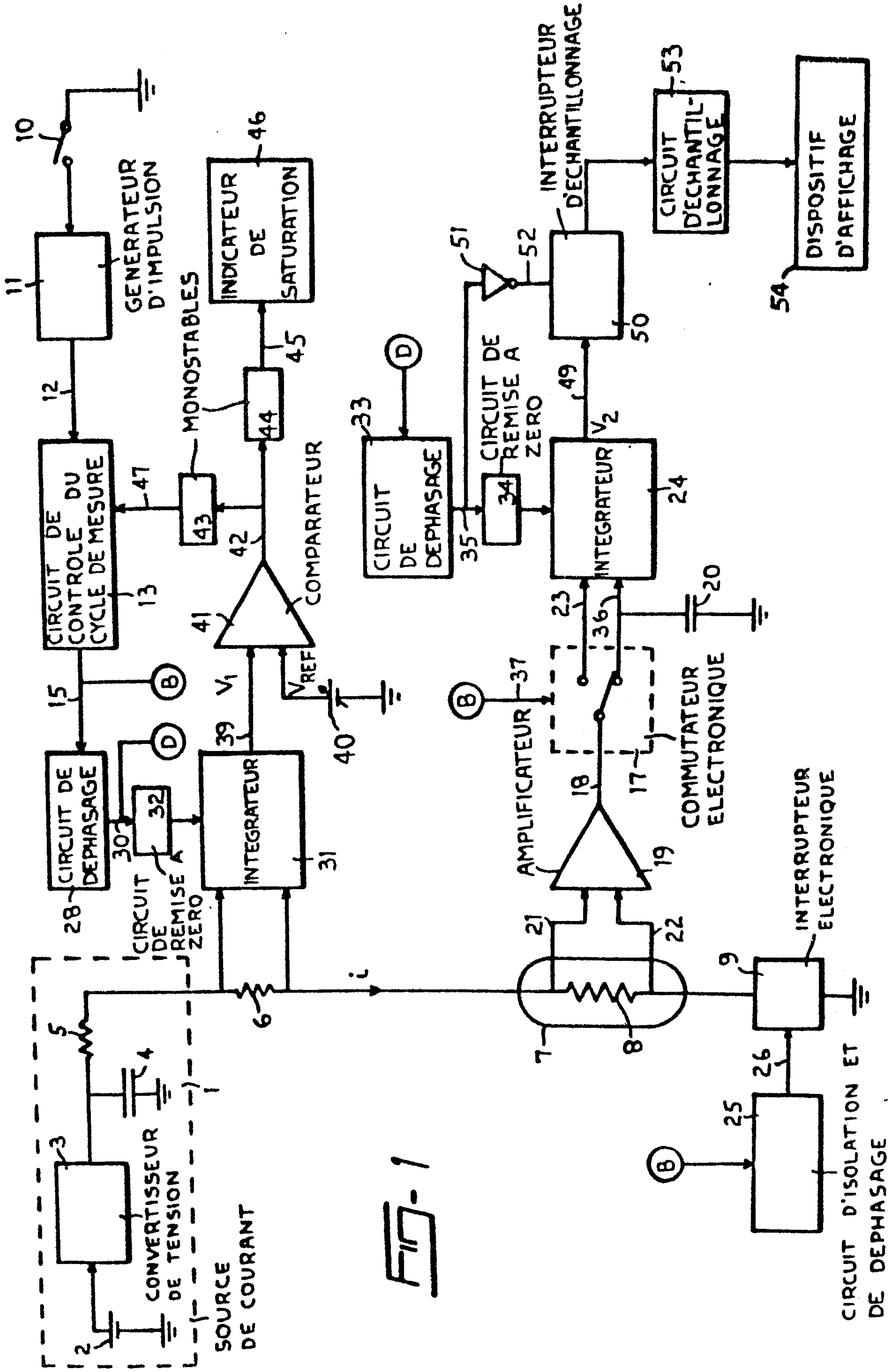
SOURCE DE COURANT
CONVERTISSEUR DE TENSION
GENERATEUR D'IMPULSION
CIRCUIT DE CONTROLE DU CYCLE DE MESURE
CIRCUIT DE DEPHASAGE
CIRCUIT DE REMISE A ZERO
INTEGRATEUR
COMPARATEUR
MONOSTABLES
INDICATEUR DE SATURATION
$V_1$
$V_{REF}$
AMPLIFICATEUR
COMMUTATEUR ELECTRONIQUE
INTERRUPTEUR ELECTRONIQUE
CIRCUIT D'ISOLATION ET DE DEPHASAGE
CIRCUIT DE DEPHASAGE
CIRCUIT DE REMISE A ZERO
INTEGRATEUR
$V_2$
INTERRUPTEUR D'ECHANTILLONNAGE
CIRCUIT D'ECHANTILLONNAGE
DISPOSITIF D'AFFICHAGE
B
D
i
2
3
4
5
6
7
8
9
10
11
12
13
15
17
18
19
20
21
22
23
24
25
26
28
30
31
32
33
34
35
36
37
39
40
41
42
43
44
45
46
47
49
50
51
52
53
54

FIG-1

Fig 2

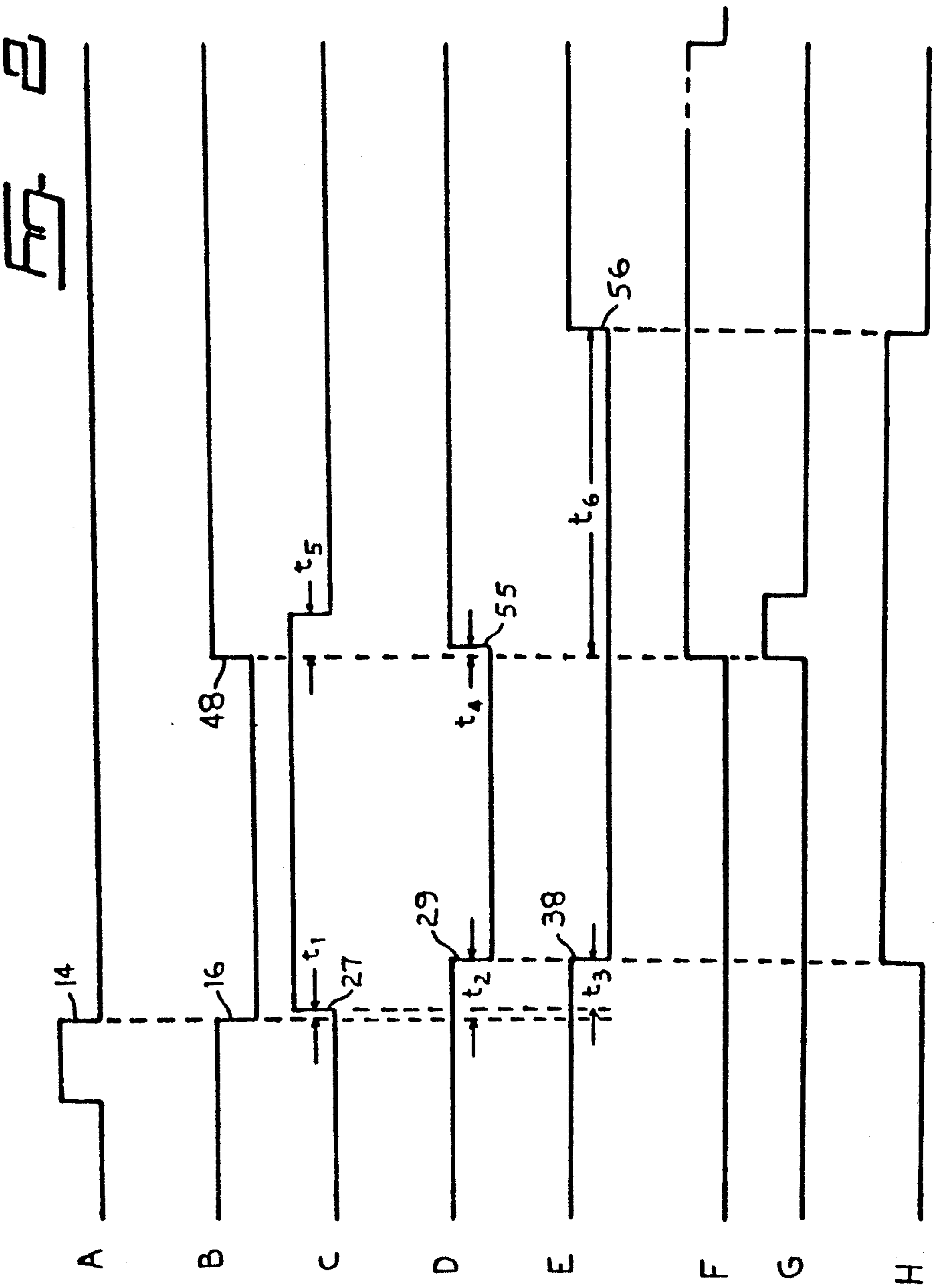

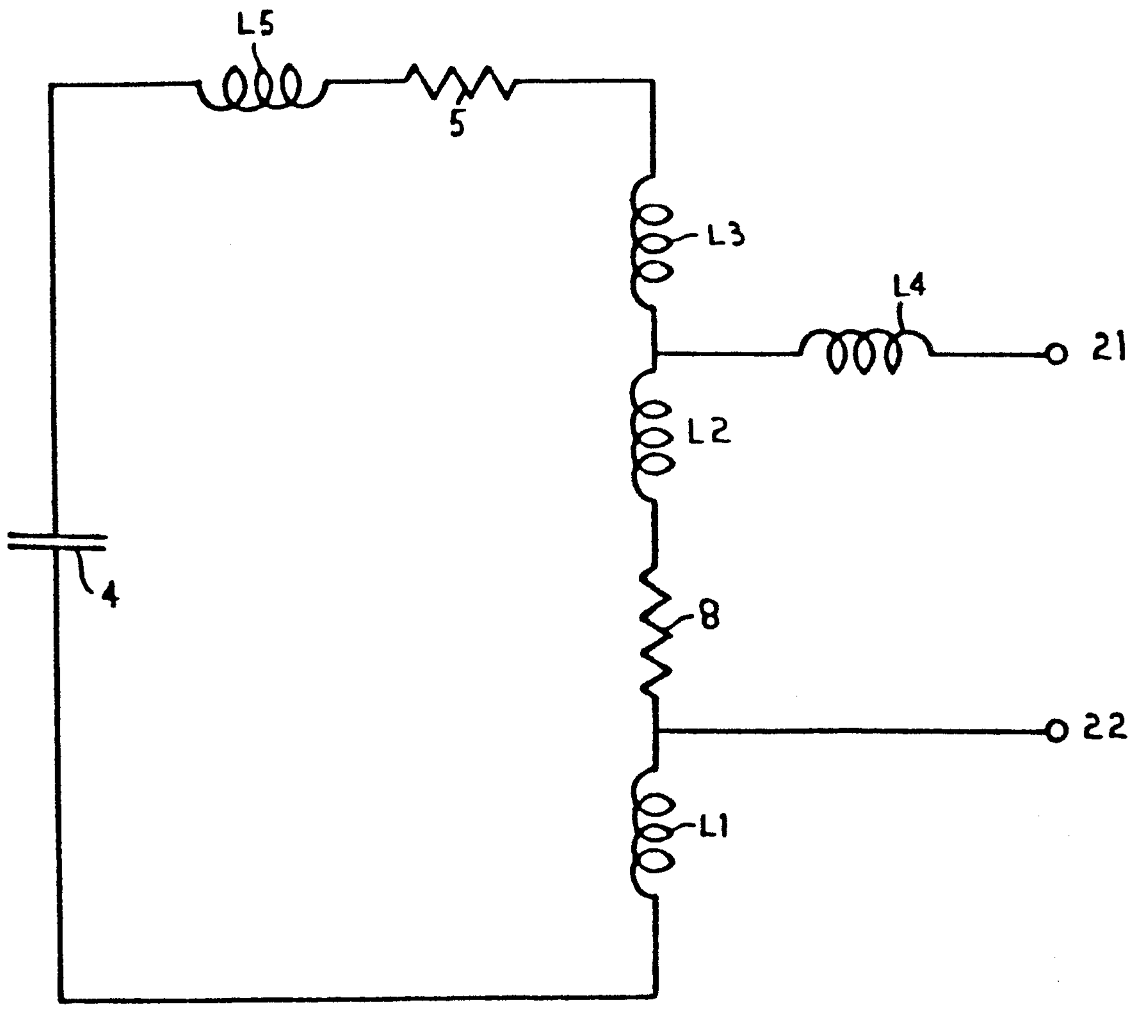


Fig. 3

Office européen des brevets

# RAPPORT DE RECHERCHE EUROPEENNE

Numéro de la demande 0210848

EP 86 40 0754

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| A | US-A-4 104 578 (M.E. THUOT)<br>* En entier *<br>--- | 1 | G 01 R 27/00<br>G 01 R 27/14<br>G 01 R 27/20 |
| A | FUNKSCHAU, no. 8, avril 1981, page 98, Munich, DE; G. OSSWALD: "Widerstands-Messung mit DVM"<br>----- | | |

| DOMAINES TECHNIQUES RECHERCHES (Int Cl 4) |
|---|
| G 01 R |

Le present rapport de recherche a été etabli pour toutes les revendications

| Lieu de la recherche | Date d achèvement de la recherche | Examinateur |
|---|---|---|
| LA HAYE | 06-10-1986 | KUSCHBERT D.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publie a la date de dépôt ou après cette date
D : cité dans la demande
L : cité pour d'autres raisons

& : membre de la même famille, document correspondant

OEB Form 1503 03 82